# EUROPÄISCHE PATENTSCHRIFT

(11) **EP 2 980 659 B1**
(45) Veröffentlichungstag und Bekanntmachung des Hinweises auf die Patenterteilung: **25.09.2019**
(21) Anmeldenummer: 14178796.0
(22) Anmeldetag: 28.07.2014
(51) Int. Cl.: G05B 9/02

(54) **Vorrichtung und Verfahren zum Überwachen und Schalten eines Lastkreises**
Device and method for monitoring and switching a load circuit
Dispositif et procédé destinés à la surveillance et la commutation d'un circuit de charge

(43) Veröffentlichungstag der Anmeldung: 03.02.2016
(73) Patentinhaber: Pepperl+Fuchs AG, 68307 Mannheim (DE)
(72) Erfinder: Oestreicher, Michael, 68307 Mannheim (DE)
(74) Vertreter: Schiffer, Axel Martin

(56) Entgegenhaltungen:
- DE-A1- 10 327 959
- GB-A- 2 294 336

## Beschreibung

Die vorliegende Erfindung bezieht sich auf eine Vorrichtung und ein Verfahren zum Überwachen und Schalten eines Lastkreises, also eines Stromkreises aus einer Lastkreisversorgung und einer Last, wobei dieser Stromkreis durch einen Lastschalter geschaltet, insbesondere geschlossen oder unterbrochen werden kann.

Im Bereich der Prozessautomatisierung werden Sensoren und/oder Aktoren (oder Aktuatoren, Effektoren, etc.), also Wandler (oder Antriebselemente, Stellglieder), die zumeist in Form elektrischer Signale vorliegende Befehle einer Steuerung (z.B. eines Steuerungscomputers) in Kräfte, Bewegungen oder andere physikalische Wirkungen (wie z.B. eine Druck- oder Temperaturänderung) umwandeln, häufig über Punkt-zu-Punkt-Verbindungen durch Steuerungen gesteuert. Zwischen der eigentlichen Steuerung und dem Sensor oder Aktor ist dabei häufig ein Schnittstellenbaustein (Interface) angeordnet, der die elektrischen Eigenschaften der von der Steuerung ausgesandten Signale an die durch die Bau- und Funktionsweise der Sensoren oder Aktoren bedingten Eigenschaften der von diesen Sensoren oder Aktoren zu empfangenen Signale anpasst. Die Steuerung befindet sich in diesen Fällen auf der Steuerungsseite des Schnittstellenbausteins, wogegen die der Steuerung abgewandte Seite des Schnittstellenbausteins die Feldseite genannt wird.

Unter dem Begriff Leitungsfehlertransparenz versteht man eine Funktion solcher Systeme, die dafür sorgt, dass ein Fehler, beispielsweise ein Leitungsbruch oder ein Kurzschluss, in der Verkabelung auf der Feldseite eines Schnittstellenbausteins auf dessen Steuerungsseite übertragen wird, so dass die Steuerung den Fehler erkennen kann, und wobei der Fehler sich auf der Steuerungsseite im Idealfall in derselben Weise für die Steuerung bemerkbar macht, als wenn dieser auf der Feldseite aufgetretene Fehler auf der Steuerungsseite des Schnittstellenbausteins vorläge.

Eine Reihe von üblichen Steuerungen bietet nämlich die Möglichkeit, Fehler wie Leitungsbrüche oder Kurzschlüsse in der Verkabelung von direkt an die Steuerung angeschlossenen Feldgeräten zu erkennen.

Wird nun zwischen die Steuerung und ein Feldgerät ein Schnittstellenbaustein geschaltet, dann kann die Steuerung nur Fehler in der Kabelverbindung auf der Steuerungsseite des Schnittstellenbausteins erkennen, nicht jedoch Fehler auf der Feldseite des Schnittstellenbausteins. Dies ist insbesondere in den Fällen besonders problematisch, in denen der Schnittstellenbaustein in der Nähe der Steuerung angeordnet ist, weil dann die verhältnismäßig lange Kabelstrecke zwischen dem Schnittstellenbaustein und dem Feldgerät unüberwacht bleibt.

GB 2 294 336 betrifft eine Steuerung für die Betätigung von Schalteinrichtungen. Ein Strompfad mit einer Last kann dabei mit einer steuerbaren Schalteinrichtung geschaltet werden. Zum Überprüfen der Schalteinrichtung wird diese mit einem Mikroprozessor einem Schaltzyklus unterworfen, wobei der tatsächliche Zustand der Schalteinrichtung mit Hilfe einer Messeinrichtung überwacht wird.

DE 103 27 959 A1 bezieht sich auf ein Überwachungsverfahren für mindestens zwei Schaltpfade. Dabei kann eine Last über eine Mehrzahl von Schaltpfaden mit Versorgungspotential verbunden werden. Mit Überwachungseinrichtungen wird für jeden Schaltpfad ein Zustandssignal erfasst und an eine übergeordnete Steuerung zurückgegeben.

Eine Aufgabe der vorliegenden Erfindung kann daher darin gesehen werden, eine technische Lehre anzugeben, mit der die geschilderte Situation nach Möglichkeit verbessert wird.

Diese Aufgabe wird durch die Vorrichtung mit den Merkmalen des Anspruchs 1 und durch das Verfahren mit den Merkmalen des Anspruchs 14 gelöst.

Bevorzugte Ausführungsbeispiele der vorliegenden Erfindung werden im Folgenden, insbesondere mit Bezug auf die abhängigen Ansprüche und die Figuren beschrieben.

Erfindungsgemäß ist eine Vorrichtung zum Überwachen und Schalten eines Lastkreises vorgesehen
- mit einem Eingangsteil und einem Ausgangsteil,
- mit Schalteingängen zum Anschließen einer Steuerung am Eingangsteil,
- mit Schaltausgängen zum Anschließen mindestens eines Lastkreises mit mindestens einer zu schaltenden Last am Ausgangsteil,
- mit mindestens einem Lastschalter zum Schalten, insbesondere zum Ein- und Ausschalten, der mindestens einen Last,
- mit einer ersten, dem Lastkreis parallel geschalteten Fehlerdetektionsschaltung zur Detektion von Fehlern im Lastkreis und
- mit einer zweiten, mit dem Lastkreis in Reihe geschalteten Fehlerdetektionsschaltung zur Detektion von Fehlern im Lastkreis.

Dabei weist das Eingangsteil eine Eingangsschaltung auf, die über die Schalteingänge eingehende Schaltbefehle der Steuerung in Schaltvorgänge der Lastschalter umsetzt. Die erste und die zweite Fehlerdetektionsschaltung erzeugen jeweils intermediäre Fehlersignale, die in einer Verknüpfungsschaltung logisch zu einem Gesamt-Fehlersignal verknüpft werden. Das Gesamt-Fehlersignal wird von dem Ausgangsteil auf das Eingangsteil übertragen und über die Schalteingänge zur Auswertung zur Verfügung gestellt.

Die erfindungsgemäße Vorrichtung zum Überwachen und Schalten eines Lastkreises oder eine ihrer bevorzugten Ausführungsformen wird vorzugsweise als Schnittstellenbaustein zwischen eine Steuerung und ein zu steuerndes Gerät auf der Feldseite, also insbesondere einen Sensor oder einen Aktor, geschaltet oder ist ein Bestandteil eines solchen Schnittstellenbausteins. In diesem Sinne ist im Folgenden auch von einem erfindungsgemäßen Schnittstellenbaustein die Rede.

Im vorliegenden Zusammenhang ist unter einem Lastkreis ein Stromkreis aus einer (nicht notwendigerweise ohmschen) Last und einer Lastkreisversorgung, also einer elektrischen Energiequelle zu verstehen, die in dem Lastkreis durch die Last einen Strom, insbesondere einen Gleichstrom oder einen Wechselstrom fließen läßt. Der Lastkreis ist ein Stromkreis in einem zu steuernden Gerät auf der Feldseite der Vorrichtung, also insbesondere in einem Sensor oder in einem Aktor.

Im vorliegenden Zusammenhang ist unter einer Last ein beliebiger allgemeiner, insbesondere auch nicht-ohmscher, elektrischer Verbraucher zu verstehen.

Im vorliegenden Zusammenhang ist unter einem Lastschalter eine Einrichtung zum Schalten einer Last oder eines Stroms in einem Lastkreis, insbesondere zum Ein- und Ausschalten einer Last oder eines Stroms in einem Lastkreis, zu verstehen.

Im vorliegenden Zusammenhang ist unter einer Vorrichtung zum Überwachen eines Lastkreises eine elektronische oder elektrische Schaltung zu verstehen, die bewirkt, dass ein Fehler, insbesondere ein Leitungsbruch oder ein Kurzschluss, im zu überwachenden Lastkreis auf der Feldseite der Vorrichtung sich als vorzugsweise gleichartiger Fehler, also insbesondere als ein Leitungsbruch oder ein Kurzschluss, auf der Steuerungsseite der Vorrichtung für die Steuerung bemerkbar macht.

Im vorliegenden Zusammenhang ist unter einem Eingangsteil einer erfindungsgemäßen Vorrichtung, insbesondere eines erfindungsgemäßen Schnittstellenbausteins, eine Teilvorrichtung, insbesondere eine Teilschaltung, zu verstehen, an die eine Steuerung über Schalteingänge angeschlossen ist oder werden kann. Das Eingangsteil empfängt über die Schalteingänge Schaltbefehle der Steuerung, empfängt ein Fehlersignal von einem Ausgangsteil der erfindungsgemäßen Vorrichtung und stellt das empfangene Fehlersignal der Steuerung über die Schalteingänge zur Auswertung zur Verfügung. Vorzugsweise geschieht dies in Form eines schaltbaren Ruhestroms im Eingangsteil, der in Abhängigkeit von dem empfangenen Fehlersignal geschaltet wird. Das Ziel der Leitungsfehlertransparenz, insbesondere die Bereitstellung eines definierten Ruhestroms am Eingangsteil der erfindungsgemäßen Vorrichtung, kann mit einer derartigen Schaltung besonders einfach und wirkungsvoll verwirklicht werden.

Im vorliegenden Zusammenhang ist unter einem Ausgangsteil einer erfindungsgemäßen Vorrichtung, insbesondere eines erfindungsgemäßen Schnittstellenbausteins, eine Teilvorrichtung, insbesondere eine Teilschaltung, zu verstehen, an die mindestens ein Lastkreis mindestens eines zu steuernden Gerätes mit mindestens einer Last über Schaltausgänge angeschlossen ist oder werden kann. Das Ausgangsteil weist wenigstens einen Lastschalter zum Schalten der wenigstens einen Last auf, die vorzugsweise in Wirkverbindung mit einer Eingangsschaltung des Eingangsteils stehen, wobei die Eingangsschaltung über die Schalteingänge eingehende Schaltbefehle der Steuerung in Schaltvorgänge der Lastschalter umsetzt.

Im vorliegenden Zusammenhang ist unter einem Schalteingang mindestens ein elektrisch leitender Anschlusskontakt des Eingangsteils einer erfindungsgemäßen Vorrichtung, insbesondere eines erfindungsgemäßen Schnittstellenbausteins, zu verstehen, über den beziehungsweise die das Eingangsteil und somit die Vorrichtung an eine Steuerung angeschlossen ist oder werden kann.

Im vorliegenden Zusammenhang ist unter einem Schaltausgang mindestens ein elektrisch leitender Anschlusskontakt des Ausgangsteils einer erfindungsgemäßen Vorrichtung, insbesondere eines erfindungsgemäßen Schnittstellenbausteins, zu verstehen, über den beziehungsweise die das Ausgangsteil und somit die Vorrichtung an einen Lastkreis angeschlossen ist oder werden kann.

Im vorliegenden Zusammenhang ist unter einer Eingangsschaltung eine Teilschaltung des Eingangsteils einer erfindungsgemäßen Vorrichtung, insbesondere eines erfindungsgemäßen Schnittstellenbausteins, zu verstehen, die über die Schalteingänge eingehende Schaltbefehle der Steuerung in Schaltvorgänge der Lastschalter umsetzt. Vorzugsweise weist eine solche Eingangsschaltung mindestens ein Relais zum Schalten wenigstens Lastschalters auf.

Im vorliegenden Zusammenhang ist unter einem Schaltbefehl einer Steuerung ein elektrisches Signal, eine Mehrzahl von gleichzeitigen elektrischen Signalen und/oder eine zeitliche Folge von elektrischen Signalen zu verstehen, die von einer Eingangsschaltung über Schalteingänge von der Steuerung empfangen und vorzugsweise mit Hilfe der Ausgangsschaltung in Schaltvorgänge der Lastschalter umgesetzt werden.

Im vorliegenden Zusammenhang ist unter einem Fehlersignal ein elektrisches, insbesondere elektromagnetisches, mechanisches, optisches oder optoelektronisches Signal oder eine Kombination solcher Signale oder einer zeitlichen Folge solcher Signale zu verstehen, das beziehungsweise die einen Fehler im Lastkreis anzeigen sollen. Unter einem intermediären Fehlersignal ist ein derartiges Fehlersignal im Ausgangsteil einer erfindungsgemäßen Vorrichtung, insbesondere eines erfindungsgemäßen Schnittstellenbausteins, zu verstehen. Unter einem übertragenen Fehlersignal oder einem Gesamt-Fehlersignal ist ein derartiges Fehlersignal im Eingangsteil einer erfindungsgemäßen Vorrichtung, insbesondere eines erfindungsgemäßen Schnittstellenbausteins, zu verstehen.

Im vorliegenden Zusammenhang ist unter einer Fehlerdetektionsschaltung eine elektrische oder elektronische Schaltung zu verstehen, die elektrisch mit wenigstens einem Lastkreis, vorzugsweise seriell oder parallel, zusammengeschaltet ist und ein Fehlersignal erzeugt, wenn in diesem wenigstens einen Lastkreis ein Fehler auftritt oder vorliegt.

Im vorliegenden Zusammenhang ist unter einer Auswertung eines Fehlersignals eine Verarbeitung dieses Fehlersignals vorzugsweise durch eine oder die Steuerung zu verstehen, deren Ergebnis in der Steuerung Einfluss auf die Arbeitsweise der Steuerung im Hinblick auf das Schalten wenigstens einer Last in wenigstens einem durch die Steuerung geschalteten Lastkreis hat.

Im vorliegenden Zusammenhang ist unter einem Ruhestrom beziehungsweise einem Ruhestrompfad ein schaltbarer, auf der Steuerungsseite der erfindungsgemäßen Vorrichtung fließender elektrischer Strom beziehungsweise eine Schaltungsanordnung zur Erzeugung eines schaltbaren Ruhestroms zu verstehen. Das Fließen des Ruhestroms signalisiert der Steuerung vorzugsweise, dass kein Leitungsbruch im Lastkreis vorliegt.

Im vorliegenden Zusammenhang ist unter einem Fehler im Lastkreis insbesondere ein Leitungsbruch oder ein Kurzschluss im Lastkreis zu verstehen.

Wird an einer Stelle eines Stromkreises, beispielsweise durch ein defektes Kabel oder durch eine lockere Steckverbindung, die Leitung aufgetrennt, liegt ein Leitungsbruch vor. Dieser verhindert einen Stromfluss in allen Betriebszuständen und ist somit grundsätzlich recht einfach zu erkennen. Bei eingeschalteter Last ist für die Erkennung eines Leitungsbruchs daher die Prüfung des Stromflusses ausreichend. Ist die Last ausgeschaltet, sieht die Erfindung beispielsweise vor, einen vorzugsweise niedrigen Prüfstrom, welcher insbesondere konstant und besonders bevorzugt so niedrig gewählt ist, dass dieser Strom die Last nicht einschalten kann, aus dem Lastkreis zu entnehmen. Wenn dieser Prüfstromstrom unterbrochen wird oder ist, kann auf einen Leitungsbruch geschlossen werden.

Ein Kurzschluss kann, je nach der Stelle, an der er auftritt, unterschiedliche Folgen haben. Dabei kommt es darauf an, ob die Spannungsversorgung der Last durch den erfindungsgemäßen Schnittstellenbaustein oder durch eine externe Spannungsversorgung realisiert ist. Im ersten Fall, wenn also die Spannungsversorgung der Last durch den erfindungsgemäßen Schnittstellenbaustein realisiert ist, gibt es typischerweise nur zwei stromführende Adern zwischen dem Schnittstellenbaustein und der Last. Tritt hier an einer beliebigen Stelle ein Kurzschluss auf, kann dieser durch eine mit dem Kurzschluss einhergehende Verringerung des Widerstandes in dem betroffenen Stromkreis erkannt werden.

Im eingeschalteten Zustand der Last wird der Strom in Folge des Kurzschlusses auf wesentlich höhere Werte ansteigen, als sie im normalen, fehlerfreien Betrieb auftreten. Diese Situation kann durch eine Schaltung erkannt werden, die solche außergewöhnlich hohen Ströme (Überströme) erkennen kann. Im ausgeschalteten Zustand der Last ist die Erkennung eines Kurzschlusses anhand der Spannung möglich, welche der Ruhestrom im Lastkreis erzeugt. Dabei müssen die Leitungswiderstände beachtet werden, welche auch im Kurzschlussfall dafür sorgen können, dass im Lastkreis eine Spannung auftritt. Falls die Ausgangsklemmen des erfindungsgemäßen Schnittstellenbausteins galvanisch von der Feldseite getrennt sind, kann ein Erd- oder Masseschluss gegebenenfalls erst beim Auftreten eins zweiten Fehlers erkannt werden.

Beinhaltet der erfindungsgemäße Schnittstellenbaustein nur Schaltelemente, welche eine externe Spannungsversorgung zu- oder abschalten, dann kann ein Kurzschluss an verschiedenen Stellen auftreten.

Ein Kurzschluss an der Spannungsquelle unterbricht die Lastversorgung und verhindert so einen Stromfluss durch die Last. Dies wirkt auf die meisten Diagnoseschaltungen wie ein Leitungsbruch, obwohl die Verkabelung an keiner Stelle aufgetrennt ist.

Tritt ein Kurzschluss über der Last auf, dann kann dies im ausgeschalteten Zustand nur sehr schwer festgestellt werden, denn die durch den Kurzschluss bewirkte Veränderung des Lastwiderstandes ist auch mit einem Ruhestrom nur schwer messbar, weil die vollständige Spannung an den geöffneten Kontakten des erfindungsgemäßen Schnittstellenbausteins anliegt. Wird der Lastkreis bei vorhandenem Lastkurzschluss eingeschaltet, löst die Sicherung der Spannungsversorgung des Lastkreises (in vielen Fällen, insbesondere bei geeigneter Dimensionierung der Sicherung) aus, wodurch sich ein Leitungsbruch ergibt. Ist dies nicht der Fall, kann der Kurzschluss über einen zu hohen Strom durch die Ausgangsklemmen des erfindungsgemäßen Schnittstellenbausteins detektiert werden.

Bei einem Kurzschluss an den Kontakten des erfindungsgemäßen Schnittstellenbausteins wird die Last ungewollt eingeschaltet. Für den Schnittstellenbaustein selbst geht die Spannung im Lastkreis jedoch auf 0 Volt zurück, was viele übliche Diagnoseschaltungen als Leitungsbruch im Lastkreis deuten.

Hat eine externe Spannungsversorgung der Last Erd- beziehungsweise Massebezug, dann kann ein Erd- beziehungsweise Masseschluss, insbesondere bei Open-Kollektor-Ausgängen zu einem ungewollten Einschalten der Last führen, Dieses Verhalten stellt sich insbesondere dann ein, wenn der Fehler an derjenigen Ader auftritt, welche die Last mit dem Ausgang des erfindungsgemäßen Schnittstellenbausteins verbindet.

Gemäß einer bevorzugten Ausführungsform der vorliegenden Erfindung wird das Gesamt-Fehlersignal an eine Schaltstufe im Eingangsteil der Vorrichtung übertragen, wobei diese Schaltstufe einen Zustand von mindestens zwei möglichen Zuständen in Abhängigkeit davon einnimmt, ob ein Fehler oder welcher Fehlertyp im Lastkreis detektiert wurde.

Auf diese Weise wird das Gesamt-Fehlersignal im Eingangsteil in der Form eines stabilen Signals dargestellt, welches von der Steuerung erkannt werden kann.

Im vorliegenden Zusammenhang ist unter einer Schaltstufe eine elektronische oder elektrische Schaltung zu verstehen, die in Abhängigkeit von einem Steuersignal, einen Strom, insbesondere in einem Ruhestrompfad, schaltet, insbesondere ein- oder ausschaltet. Beispiele für Schaltstufen in diesem Sinne sind über einen oder mehrere Transistoren angesteuerte Relais oder Halbleiterschaltungen. Im vorliegenden Zusammenhang ist unter einer geschalteten Schaltstufe eine Schaltstufe im geschalteten Zustand zu verstehen. Entsprechend ist unter einer nicht geschalteten Schaltstufe eine Schaltstufe im nicht geschalteten Zustand zu verstehen.

Gemäß einer weiteren bevorzugten Ausführungsform der vorliegenden Erfindung schaltet die Schaltstufe einen Ruhestrom in einem Ruhestrompfad im Eingangsteil. So "sieht" die Steuerung am Eingangsteil der erfindungsgemäßen Vorrichtung einen Zustand, der dem Zustand entspricht, den die Steuerung "sähe", wenn die Steuerung direkt mit dem Lastkreis verbunden wäre. In diesem Sinne liegt hier also ein hohes Maß an Leitungsfehlertransparenz vor.

Gemäß einer weiteren bevorzugten Ausführungsform der vorliegenden Erfindung hat der Ruhestrom im Wesentlichen gleiche Stärke wie der Prüfstrom. Das Prinzip der Leitungsfehlertransparenz wird durch diese Ausführungsform in noch höherem Maße verwirklicht.

Gemäß einer weiteren bevorzugten Ausführungsform der vorliegenden Erfindung bewirkt die Verknüpfungsschaltung eine ODER-Verknüpfung der intermediären Fehlersignale. Auf diese Weise zeigt das Gesamt-Fehlersignal einen Fehler an, sobald eines der intermediären Fehlersignale einen Fehler anzeigt.

Gemäß einer weiteren bevorzugten Ausführungsform der vorliegenden Erfindung weist die erste Fehlerdetektionsschaltung eine Stromregelung zum Entnehmen eines Prüfstroms aus dem Lastkreis auf, wobei das von der ersten Fehlerdetektionsschaltung erzeugte erste intermediäre Fehlersignal unterschiedlich ist, je nachdem, ob der Prüfstrom fließt oder unterbrochen ist. Diese Ausführungsform ermöglicht eine besonders einfache Fehlerdetektion und eine transparente Übermittlung von Fehlerzuständen vom Ausgangsteil auf das Eingangsteil.

Gemäß einer weiteren bevorzugten Ausführungsform der vorliegenden Erfindung ist der Prüfstrom gegenüber einem im Lastfall im Lastkreis fließenden Strom vernachlässig bar klein. Diese Ausführungsform ermöglicht eine Fehlerdetektion mit sehr geringer Störwirkung auf das Geschehen im Lastkreis.

Gemäß einer weiteren bevorzugten Ausführungsform der vorliegenden Erfindung ist der Prüfstrom konstant. Diese Ausführungsform ermöglicht eine Fehlerdetektion, die besonders robust ist gegenüber Schwankungen der Ströme im Lastkreis.

Gemäß einer weiteren bevorzugten Ausführungsform der vorliegenden Erfindung weist die erste Fehlerdetektionsschaltung einen Gleichrichter zur Gleichrichtung des Prüfstroms auf. Dieser Gleichrichter bewirkt, dass ein im Lastkreis fließender Wechselstrom in dem parallel zum Lastkreis geschalteten Prüfstromkreis gleichgerichtet wird. Auf diese Weise kann die Fehlerdetektionsschaltung unabhängig davon arbeiten, ob im Lastkreis ein Gleichstrom oder ein Wechselstrom fließt.

Gemäß einer weiteren bevorzugten Ausführungsform der vorliegenden Erfindung weist die erste Fehlerdetektionsschaltung eine Schaltung zur Erkennung eines Leitungsbruchfehlers im Lastkreis auf. Die erste Fehlerdetektionsschaltung ist parallel zum Lastkreis und parallel zu den Kontakten des Lastkreises geschaltet. Sind die Lastkreisschalter geöffnet, liegt an diesen Schaltern die Spannung aus der Lastkreisversorgung an. Diese Spannung kann mit einem vorzugsweise geringen Strom, dem Prüfstrom, belastet werden. Solange die Lastkreisverdrahtung fehlerfrei ist, kann mit diesem Prüfstrom ein Signal erzeugt werden. Die erste Fehlerdetektionsschaltung erzeugt dieses Logik-Signal aus dem Prüfstrom. Als intermediäres Fehlersignal der ersten Fehlerdetektionsschaltung wird es vorzugsweise über eine galvanische Trennung, besonders vorzugsweise über ein Relais, an das Eingangsteil übertragen und den Schalteingängen zur Auswertung durch die Steuerung zur Verfügung gestellt. Die galvanische Trennung, vorzugsweise ein Relais oder ein Optokoppler oder ähnliches, wird vorzugsweise mit einer Betriebsspannung betrieben, die der erfindungsgemäßen Vorrichtung, vorzugsweise dem erfindungsgemäßen Schnittstellenbaustein, über eine eigene Energieversorgung zugeführt wird. Alternativ dazu könnte die galvanische Trennung auch mit einer dem Lastkreis oder der Steuerung entnommenen Energie betrieben werden. Die eigene Energieversorgung der erfindungsgemäßen Vorrichtung, vorzugsweise des erfindungsgemäßen Schnittstellenbausteins, bietet aber den Vorteil, dass keine Annahmen über die Strombelastbarkeit des Lastkreises oder Steuerung getroffen werden müssen.

Fällt der Prüfstrom weg, kann auf einen Fehler im Lastkreis geschlossen werden. Die erste Fehlerdetektionsschaltung erzeugt ein intermediäres Fehlersignal, dessen logischer Wert den Wegfall des Prüfstroms anzeigt. Das Relais im Eingangsteil öffnet und unterbricht in diesem Fehlerfall den Ruhestromkreis im Eingangsteil und zeigt somit den Leitungsbruch im Lastkreis in der Form eines Leitungsbruches im Steuerkreis an.

Gemäß einer weiteren bevorzugten Ausführungsform der vorliegenden Erfindung weist die zweite Fehlerdetektionsschaltung eine Schaltung zur Erkennung eines Leitungsbruchfehlers im Lastkreis auf. Diese Schaltung zur Erkennung eines Leitungsbruchfehlers im Lastkreis der zweiten, in Serie zum Lastkreis geschalteten Fehlerdetektionsschaltung hat den Vorteil, dass auch bei geschlossenen Lastkreisschaltern des Lastkreises, wenn an den Lastkreisschaltern keine Spannung zur Verfügung steht, mit der ein Prüfstrom generiert werden könnte, eine ein Leitungsbruchfehler im Lastkreis erkannt werden kann.

Gemäß einer weiteren bevorzugten Ausführungsform der vorliegenden Erfindung weist die zweite Fehlerdetektionsschaltung eine Schaltung zur Erkennung eines Kurzschlussfehlers im Lastkreis auf.

Eine separate, eigenständige Energieversorgung der erfindungsgemäßen Vorrichtung bietet die Möglichkeit, Schaltungen zur Fehlerdetektion in Serie zu den Lastkreisschaltern zu betreiben. Auf diese Weise ist auch bei geschlossenen (also elektrisch leitfähigen) Lastkreisschaltern der Nachweis eines (oberhalb einer Maximalschwelle liegenden) Überstroms oder eines ausgefallenen (unterhalb einer Minimalschwelle liegenden) Stroms im Lastkreis möglich, wodurch die Erkennung eines Kurzschlusses (insbesondere an der Last) oder eines Leitungsbruchs möglich wird.

Dabei äußert sich ein Kurzschluss durch einen Überstrom und ein Leitungsbruch durch einen Stromausfall im Lastkreis.

Vorzugsweise wird die eigenständige Energieversorgung der erfindungsgemäßen Vorrichtung mit Hilfe einer sogenannten Power Rail realisiert. Dabei handelt es sich um ein Einlegeteil für eine 35 mm Normschiene das vorzugsweise drei oder fünf Stromschienen besitzt. Zwei dieser Schienen versorgen Geräte mit entsprechenden Kontakten mit einer Spannung von vorzugsweise 24V DC. Die Schiene kann für eine Sammelfehlermeldung genutzt werden. Sobald an einem mit der Power Rail kompatiblen Gerät ein Fehler auftritt überträgt dieses Gerät den Fehler auf die Schiene. Dort kann der Fehler für alle auf der Schiene befindlichen Geräte ausgelesen und an die zuständige Steuerung übertragen werden.

So können mit einem Eingang alle auf der Schiene befindlichen Geräte auf Fehler überwacht werden. Unbenutzte Schienen können von entsprechend ausgestatteten Geräten für eine Bus-Kommunikation genutzt werden.

Vorzugsweise wird die erfindungsgemäße Vorrichtung von der Power Rail galvanisch getrennt, besonders vorzugsweise durch ein Schaltnetzteil. Dies bietet den Vorteil, dass die Fehlerkennungsschaltungen falls erforderlich auch mit einer anderen Spannung als 24V betrieben werden kann. Durch die eigenständige Energieversorgung der erfindungsgemäßen Vorrichtung steht auch bei eingeschaltetem Lastkreis Energie zum Betrieb der Fehlerkennungsschaltungen zur Verfügung, wodurch eine größere Zahl unterschiedlicher Fehler erkannt werden kann als mit Hilfe von Fehlererkennungsschaltungen, die nur bei geöffneten, das heißt elektrisch nicht leitfähigen, Lastkreisschaltern betrieben werden können.

Die zweite, seriell zum Lastkreis geschaltete Fehlerdetektionsschaltung weist vorzugsweise geeignete Teilschaltungen zur Erkennung von Stromausfällen und/oder Überströmen im Lastkreis auch bei geschlossenen Lastkreisschaltern auf. Mit derart ausgestalteten ersten und zweiten Fehlerdetektionsschaltungen können also Leitungsbrüche bei geöffneten Lastkreisschaltern und Leitungsbrüche und/oder Kurzschlüsse bei geschlossenen Lastkreisschaltern detektiert werden. Diese drei unterschiedlichen Fehlerarten können im Eingangsteil der erfindungsgemäßen Vorrichtung durch die Steuerung noch unterschieden werden, wenn die unterschiedlichen intermediären Fehlersignale zu einem Gesamt-Fehlersignal verknüpft werden, dass eine Unterscheidung noch möglich macht. Bei einer einfachen ODER-Verknüpfung der intermediären Fehlersignale ist das allerdings nicht ohne Weiteres möglich.

Die erste, dem Lastkreis parallel geschaltete Fehlerdetektionsschaltung zur Detektion von Fehlern im Lastkreis kann ohne eine eigenständige Energieversorgung der erfindungsgemäßen Vorrichtung realisiert werden. Aufgrund des bei einigen Anwendungen großen Spannungs- und Strombereichs ist eine Kurzschlusserkennung bei geöffneten Lastkreisschaltern, wenn überhaupt möglich, jedenfalls schwieriger als bei geschlossenen Lastkreisschaltern. Ist der Ausgang eingeschaltet, das heißt die Lastkreisschalter geschlossen, kann der Zustand der Leitungen über eine Messung des Laststroms erkannt werden. Fällt dieser unter einen Minimalwert, kann von einem Leitungsbruch ausgegangen werden. Übersteigt er ein Maximum, ist von einem Kurzschluss auszugehen.

Eine Messung dieses Stromes kann wegen des großen Bereichs, in dem er sich bewegen kann, schwierig werden. Typische Stromobergrenzen für die erfindungsgemäße Vorrichtung liegen bei beispielsweise 5A. Typische Mindeststromstärken, für den eine einwandfreie Funktion garantiert werden kann, liegen bei 2mA. Die Strommessung muss innerhalb des Gehäuses des Relaisbausteins erfolgen, in dem schon andere Komponenten eine Verlustleistung produzieren. Deshalb ist bei der Strommessung darauf zu achten, dass nicht zu viel Energie in Warme umgesetzt wird.

Wird für die Messung ein einfacher Shunt-Widerstand verwendet, ergibt sich bei einer gewünschten Spannung von 100mV und einem Strom von 5A ein Widerstandswert von 20mΩ. Die Verlustleistung liegt dann bei 0,5W. Bei einem Strom von 2mA liegen jedoch nur 40µV an, welche in dem erfindungsgemäßen Schnittstellenbaustein schwierig zu detektieren sind. Aus diesem Grund ist es vorteilhaft, zur Messung der Ströme zwei unterschiedliche Diagnoseschaltungen zu verwenden, eine für die Unterschreitung des Minimalstroms und eine andere für die Überschreitung des Maximalstroms.

Wegen der eigenständigen Energieversorgung der erfindungsgemäßen Vorrichtung und/oder des erfindungsgemäßen Schnittstellenbausteins wird zur Fehlersimulation in der Eingangsschaltung vorzugsweise ein Relais verwendet. Da dieses den Stromkreis vollständig auftrennt, ist eine zuverlässige Erkennung als Leitungsbruch sichergestellt. Weitere Vorteile des Relais sind die automatisch vorhandene galvanische Trennung und die einfache Ansteuerung mit einer Gleichspannung. Im fehlerfreien Zustand wird die Eingangsschaltung nicht verändert, wodurch hier keine Anpassung notwendig ist.

Im eingeschalteten Zustand, also bei geschlossenen Lastkreisschaltern, wird dann ein Leitungsbruch erkannt, wenn der minimale, zur Funktion notwendige Strom unterschritten wird. Dieser wird anwendungsspezifisch festgelegt und beträgt beispielsweise 2mA.

Wird zur Messung des Stroms ein Shunt-Widerstand verwendet, muss dieser bei einem Strom von 2mA eine gut auszuwertende Spannung liefern. Der dazu notwendige Widerstandswert wäre allerdings so hoch, dass die bei einem Strom von 5A erzeugte Verlustleistung nicht aus dem Gehäuse der erfindungsgemäßen Vorrichtung (oder des erfindungsgemäßen Schnittstellenbausteins) abgeführt werden könnte. Dieses Problem kann durch einen relativ hochohmigen Shunt-Widerstand gelöst werden, der ab einem gewissen Strom durch einen MOS-FET überbrückt wird.

Die Detektion eines Kurzschlusses im eingeschalteten Zustand erfolgt vorzugsweise, ähnlich wie die Leitungsbruchprüfung, anhand einer Strommessung. Hierbei wird davon ausgegangen, dass, sobald der Strom einen vorgegebenen Maximalwert von 5A für längere Zeit übersteigt, ein Kurzschluss vorliegt. Da dazu nur die Überwachung des Maximalwerts notwendig ist, kann ein normaler Shunt-Widerstand eingesetzt werden.

Für die Leitungsbrucherkennung im ausgeschalteten Zustand, also bei geöffneten Lastkreisschaltern, wird ein Prüfstrompfad parallel zum Lastkreis geschaltet, welcher für einen geringen Stromfluss durch die Last sorgt. Fließt dieser Strom nicht, ist von einem Leitungsbruch auszugehen. Die erste Fehlerdetektionschaltung erzeugt in diesem Fall ein entsprechendes intermediäres Fehlersignal, welches gegebenenfalls mit anderen intermediären Fehlersignalen zum einem Gesamt-Fehlersignal verknüpft und vom Ausgangsteil an das Eingangsteil zur Auswertung durch die Steuerung übertragen wird.

Ohne eine eigenständige Energieversorgung der erfindungsgemäßen Vorrichtung oder des erfindungsgemäßen Schnittstellenbausteins wären lediglich Leitungsbrüche im ausgeschalteten Zustand erkennbar.

Gemäß einer weiteren bevorzugten Ausführungsform der vorliegenden Erfindung wird das Gesamt-Fehlersignal vom Ausgangsteil auf das Eingangsteil in galvanisch getrennter Weise übertragen. So wird die Steuerung auch solcher Lastkreise mit herkömmlichen Steuerungen möglich, in denen Lasten mit hohen Strömen beaufschlagt sind. Außerdem verhindert eine geeignet ausgestaltete galvanische Trennung unerwünschte Rückwirkungen von Störungen im Lastkreis auf die Steuerung.

Im vorliegenden Zusammenhang ist unter einer galvanischen Trennstufe eine Einrichtung zu verstehen, die eine Informationsübertragung zwischen zwei elektrischen Schaltungen ohne eine elektrisch leitfähige Verbindung zwischen diesen beiden elektrischen Schaltungen ermöglicht. Wichtige Beispiele für solche galvanischen Trennungen oder Trennstufen sind induktive Trennstufen in Form von Transformatoren mit elektrisch voneinander getrennten Spulen, vorzugsweise auf einem gemeinsamen Eisenkern, kapazitive Trennstufen, elektromechanische Bauteile wie beispielsweise Relais oder optoelektronische Wandler, insbesondere sogenannte Optokoppler. Unter der galvanisch getrennten Übertragung eines Fehlersignals, insbesondere von dem Ausgangsteil auf das Eingangsteil, ist entsprechend eine Übertragung eines Fehlersignals, insbesondere von dem Ausgangsteil auf das Eingangsteil, ohne eine elektrisch leitfähige Verbindung, insbesondere von dem Ausgangsteil auf das Eingangsteil, zu verstehen.

Vorzugsweise wird diese galvanische Trennung mit Hilfe eines Relais oder eines Optokopplers durchgeführt.

Optokoppler sind optoelektronische Übertrager zwischen zwei galvanisch getrennten Stromkreisen. Sie haben im Vergleich zu anderen galvanischen Trennungen eher geringe Abmessungen, ermöglichen sowohl eine digitale als auch eine analoge Übertragung eines Fehlersignals und weisen keine Induktivitäten auf, die als Quelle von streuenden elektromagnetischen Feldern in Betracht kämen. Auch sind sie unempfindlich gegen störende äußere elektromagnetische Felder und besitzen geringere Verzögerungszeiten und einen geringeren Verschleiß als elektromechanische Lösungen. Im Vergleich zu induktiven Lösungen zur galvanisch getrennten Übertragung wie Relais oder Transformatoren ist der Ein- und/oder Ausgangskreis solcher optoelektronischen Übertrager jedoch häufig empfindlicher gegenüber einer Überlastung oder gegenüber Störimpulsen.

Gemäß einer weiteren bevorzugten Ausführungsform der vorliegenden Erfindung weist die Eingangsschaltung eine Spule auf, die mit wenigstens einem Lastschalter in Wirkverbindung steht.

Diese bevorzugte Ausführungsform bewirkt eine galvanisch getrennte Übertragung der Schaltbefehle der Steuerung vom Eingangsteil auf das Ausgangsteil und somit die sichere Steuerung auch von Starkstromlasten durch Steuerungen auf der Grundlage üblicher Digitalschaltungen ohne den Einsatz von Leistungshalbleitern.

Ferner ist erfindungsgemäß ein Verfahren zum Überwachen und Schalten eines Lastkreises mit einer Last vorgesehen, bei dem
- zwischen eine Steuerung und den Lastkreis eine Vorrichtung mit einem Eingangsteil und einem Ausgangsteil geschaltet wird oder ist,
- das Eingangsteil eine Eingangsschaltung aufweist, die über Schalteingänge eingehende Schaltbefehle der Steuerung in Schaltvorgänge der Lastschalter umsetzt,
- mindestens eine erste, dem Lastkreis parallel geschaltete Fehlerdetektionsschaltung, und mindestens eine zweite, seriell zum Lastkreis geschaltete Fehlerdetektionsschaltung Fehler im Lastkreis detektiert und mindestens je ein intermediäres Fehlersignal im Ausgangsteil erzeugt,
- eine Verknüpfungsschaltung aus den intermediären Fehlersignalen ein aus diesen intermediären Fehlersignalen abgeleitetes Gesamt-Fehlersignal erzeugt und von dem Ausgangsteil auf das Eingangsteil überträgt, und bei dem
- das Gesamt-Fehlersignal über die Schalteingänge zur Auswertung zur Verfügung gestellt wird.

Gemäß einer bevorzugten Ausführungsform des erfindungsgemäßen Verfahrens ist oder wird zwischen die Steuerung und den Lastkreis eine erfindungsgemäße Vorrichtung, insbesondere nach einer der beschriebenen bevorzugten Ausführungsformen geschaltet.

Weitere vorteilhafte Ausführungsbeispiele der Erfindung werden nachstehend mit Bezug auf die beigefügten schematischen Figuren erläutert. Hierin zeigen:
- Fig. 1: eine schematische Darstellung einer erfindungsgemäßen Anordnung einer erfindungsgemäßen Vorrichtung zum Überwachen und Schalten eines Lastkreises zwischen einer Steuerung und einem Lastkreis;
- Fig. 2: schematische Darstellungen einer Anordnung eines Schnittstellenbausteins nach dem Stand der Technik zwischen einer Steuerung und Lastkreisen;
- Fig. 3: eine schematische Darstellung eines Ausführungsbeispiels einer erfindungsgemäßen Vorrichtung zum Überwachen und Schalten eines Lastkreises;
- Fig. 4: eine schematische Darstellung eines weiteren Ausführungsbeispiels einer erfindungsgemäßen Vorrichtung zum Überwachen und Schalten eines Lastkreises;
- Fig. 5: eine schematische Darstellung eines Ausführungsbeispiels einer Teilschaltung der erfindungsgemäßen Vorrichtung.

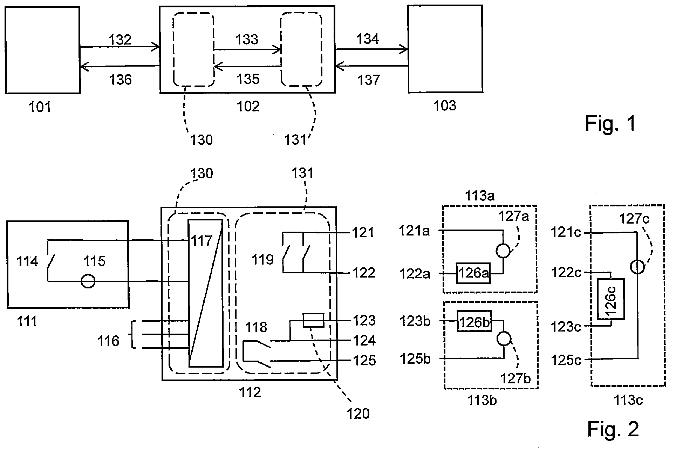

Ein typischer, der vorliegenden Erfindung zugrundeliegender allgemeiner Aufbau einer Anordnung aus einer Steuerung 101, einem Schnittstellenbaustein 102 und einem Lastkreis 103 wird in Fig. 1 gezeigt.

Der Lastkreis ist der Stromkreis eines auf der Feldseite des erfindungsgemäßen Schnittstellenbausteins 102 an den Schnittstellenbaustein 102 angeschlossenen Gerätes 103, wie zum Beispiel eines Aktors oder eines Sensors. In dem Schnittstellenbaustein 102 befindet sich ein Eingangsteil 130 und ein Ausgangsteil 131. Die Steuerung 101 sendet Steuersignale 132 an den erfindungsgemäßen Schnittstellenbaustein, die durch das Eingangsteil 130 empfangen und in Steuersignale 133 des Eingangsteils an das Ausgangsteil 131 umgesetzt werden. Das Ausgangsteil 131 steuert 134 wiederum den Lastkreis 103. Fehler im Lastkreis wirken sich 137 auf die Fehlererkennung im Schnittstellenbaustein aus und werden von Schaltungen zur Fehlererkennung oder Fehlerdetektion des Ausgangsteils an das Eingangsteil übergeben 135. Der erfindungsgemäße Schnittstellenbaustein bewirkt auf diese Weise eine Fehlersimulation 136 eines Fehlers im Lastkreis für die Steuerung 101.

Die vorliegende Erfindung ermöglicht dabei eine Leitungsfehlertransparenz in dem Sinn, dass ein Fehler, beispielsweise ein Leitungsbruch oder ein Kurzschluss, in der Verkabelung auf der Feldseite eines erfindungsgemäßen Schnittstellenbausteins auf dessen Steuerungsseite übertragen wird, so dass die Steuerung den Fehler erkennen kann, wobei der Fehler sich auf der Steuerungsseite in ähnlicher oder in derselben Weise für die Steuerung bemerkbar macht, als wenn dieser auf der Feldseite aufgetretene Fehler auf der Steuerungsseite des erfindungsgemäßen Schnittstellenbausteins vorläge.

Fig. 2 zeigt eine Anordnung nach dem Stand der Technik, mit einem Schnittstellenbaustein 112 nach dem Stand der Technik, dessen Eingangsteil 130 ein Relais 117 aufweist, mit dem die Schalter 118 und 119 in dem Ausgangsteil 131 geschaltet werden können. Der Strom durch das Relais 117 stammt aus einer Stromquelle 115 der Steuerung 111, die mit Hilfe eines Schalters 114 der Steuerung geschaltet wird. Das Eingangsteil 130 des Schnittstellenbausteins 112 kann außerdem über Testeingänge 116 verfügen.

In der in Figur 2 dargestellten Anordnung aus dem Stand der Technik sind die Schalter 118 in Reihe geschaltet, wodurch ein sicheres Ausschalten des Lastkreises 113b möglich wird. Der Lastkreis 113b besteht aus der Last 126b und der Lastkreisversorgung 127b und ist über die Kontakte 123b und 125b mit den Ausgangsklemmen 123 und 125 der Ausgangsschaltung 131 verbunden, wobei in dem hier gezeigten Beispiel noch eine Sicherung 120 vorgesehen ist. Die Schalter 119 sind parallel geschaltet, wodurch ein sicheres Einschalten des Lastkreises 113a ermöglicht wird, der aus einer Last 126a und einer Lastversorgung 127a besteht und über die Anschlüsse 121a und 122a mit den Anschlussklemmen 121 und 122 der Ausgangsschaltung 131 verbunden ist. Der aus der Last 126c und der Lastkreisversorgung 127c bestehende Lastkreis 113c ist über die Anschlüsse 121c, 122c, 123c und 125c mit den Anschlüssen 121, 122, 123 und 125 des Schnittstellenbausteins 112 verbunden und kann dadurch all-polig ein- und ausgeschaltet werden. Eine Redundanz der Schaltkontakte entfällt dabei allerdings.

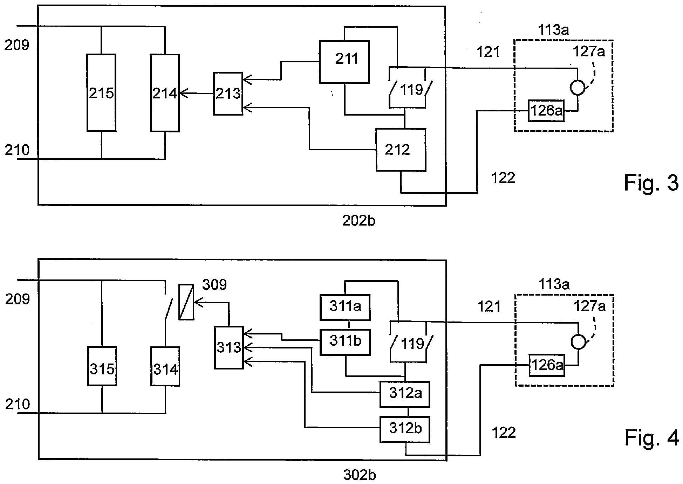

Die Fig. 3 zeigt eine weitere Ausführungsform der Erfindung, bei der der erfindungsgemäße Schnittstellenbaustein 202b zwei Fehlerdetektionsschaltungen 211 und 212 aufweist, wobei die Fehlerdetektionsschaltung 211 parallel zum Lastkreis 113a geschaltet ist und wobei die Fehlerdetektionsschaltung 212 seriell in den Lastkreis 113a integriert ist. Durch die Fehlerdetektionsschaltung 212 fließt also nur dann ein Strom, wenn zumindest einer der Schalter 119 geschlossen ist, wogegen an der Fehlerdetektionsschaltung 211 nur dann eine Spannung anliegt, wenn beide Schalter 119 geöffnet sind. Die Verknüpfungsschaltung 213 verknüpft die Ergebnisse der Fehlerdetektionen 211 und 212 und das Verknüpfungsergebnis schaltet die Ruhestromschaltstufe 214, die parallel zur Eingangsschaltung 215 angeordnet ist, welche die Schalter 119 betätigt.

Die Fehlersignale werden - mit oder ohne galvanische Trennung - über eine Verknüpfungsschaltung, vorzugsweise ein ODER-Gatter, von der Ausgangsseite auf die Eingangsseite übertragen. Eine Kippstufe und ein Übertrager mit nachgeschaltetem Gleichrichter werden hierzu nicht unbedingt benötigt. Die Steuerung des schaltbaren Ruhestromzweigs 214 kann auch galvanisch getrennt über ein Relais erfolgen.

Fig. 4 zeigt eine Konkretisierung des in Fig. 3 gezeigten Ausführungsbeispiels, bei dem die Fehlerdetektionsschaltung 211 einen Prüfstromzweig 311a und eine Schaltung zur Leitungsbrucherkennung 311b aufweist, und bei dem die Fehlerdetektionsschaltung 212 eine Schaltung zur Leitungsbrucherkennung 312a und eine Schaltung zur Kurzschlusserkennung 312b aufweist. Die Ausgangssignale der Fehlerdetektionsschaltungen 311b, 312a und 312b werden in der Verknüpfungsschaltung 313, beispielsweise einem ODER-Gatter, logisch verknüpft und das Ergebnis dieser Verknüpfung steuert ein Relais 309, welches den Ruhestromzweig 314 schaltet. Das Relais öffnet einen seriellen Kontakt im Eingangskreis, was von der Steuerung detektiert werden kann. Die Eingangsschaltung 315 betätigt die Schalter 119.

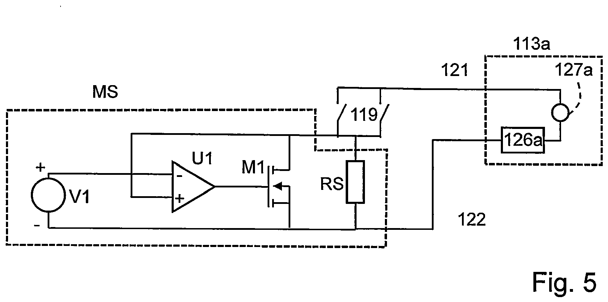

Fig. 5 zeigt eine bevorzugte Schaltung MS zur Überbrückung des Mess-Shunt-Widerstandes RS, durch den der Lastkreisstrom bei geschlossenen Lastkreisschaltern 119 fließt und an dem dann eine diesem Lastkreisstrom und dem Mess-Shunt-Widerstands RS proportionale Spannung abfällt. Ab einer gewissen Stromstärke des Lastkreisstroms wird der Mess-Shunt-Widerstand durch den MOS-FET M1 überbrückt, wenn der Operationsverstärker U1, der die an RS abfallende Spannung mit der Referenzspannung V1 vergleicht, den MOS-FET M1 durchschaltet. Hierdurch werden an RS ohne diese Schaltung möglicherweise entstehende zu große Verlustleistungen vermieden. Die Schaltung bestehend aus V1, U1 und M1 kann bei Bedarf auch zweifach antiparallel aufgebaut sein, um die Verwendung mit Wechselstrom bzw. Gleichstrom unbekannter Polarität zu ermöglichen.

### Bezugszeichenliste

- 101: Steuerung
- 102: erfindungsgemäßer Schnittstellenbaustein, Vorrichtung zum Überwachen und Schalten eines Lastkreises
- 103: Lastkreis, Feldseitiges Gerät, Aktor, Sensor
- 111: Steuerung
- 112: Schnittstellenbaustein nach dem Stand der Technik
- 113a: Lastkreis
- 113b: Lastkreis
- 113c: Lastkreis
- 114: Schalter
- 115: Stromquelle
- 116: Testeingänge
- 117: Relais
- 118: serielle Schalter
- 119: parallele Schalter
- 120: Sicherung
- 121: Ausgangsklemme des Schnittstellenbausteins
- 122: Ausgangsklemme des Schnittstellenbausteins
- 123: Ausgangsklemme des Schnittstellenbausteins
- 124: Ausgangsklemme des Schnittstellenbausteins
- 125: Ausgangsklemme des Schnittstellenbausteins
- 121a: Eingangsklemme eines Lastkreises
- 121c: Eingangsklemme eines Lastkreises
- 122a: Eingangsklemme eines Lastkreises
- 122c: Eingangsklemme eines Lastkreises
- 123b: Eingangsklemme eines Lastkreises
- 123c: Eingangsklemme eines Lastkreises
- 125b: Eingangsklemme eines Lastkreises
- 125c: Eingangsklemme eines Lastkreises
- 126a: Last
- 126b: Last
- 126c: Last
- 127a: Stromversorgung in einem Lastkreis
- 127b: Stromversorgung in einem Lastkreis
- 127c: Stromversorgung in einem Lastkreis
- 130: Eingangsteil
- 131: Ausgangsteil
- 132: Steuersignale an Schnittstellenbaustein
- 133: Steuerung des Ausgangsteils durch das Eingangsteil
- 134: Steuerung des Lastkreises durch das Ausgangsteil
- 135: Fehlermeldung des Ausgangsteils an das Eingangsteil
- 136: Fehlersimulation des Schnittstellenbausteins für die Steuerung
- 137: Auswirkung eines Lastkreisfehlers auf die Fehlererkennung
- 202a: erfindungsgemäßer Schnittstellenbaustein
- 202b: erfindungsgemäßer Schnittstellenbaustein
- 203: Stromregelung
- 204: Kippstufe
- 205: Übertrager, Transformator, galvanische Trennstufe
- 205a: Primärseitiger Eingang der galvanischen Trennstufe
- 205b: Sekundärseitiger Ausgang der galvanischen Trennstufe
- 209: Eingangsklemme des Schnittstellenbausteins
- 210: Eingangsklemme des Schnittstellenbausteins
- 211: erste Fehlerdetektionsschaltung
- 212: zweite Fehlerdetektionsschaltung
- 213: Verknüpfungsschaltung
- 214: Ruhestromschaltstufe
- 215: Eingangsschaltung
- 302a: erfindungsgemäßer Schnittstellenbaustein
- 302b: erfindungsgemäßer Schnittstellenbaustein
- 307: Ruhestromzweig
- 308: MOSFET
- 309: Relais
- 311a: Prüfstromzweig
- 311b: Leitungsbrucherkennung
- 312a: Leitungsbrucherkennung
- 312b: Kurzschlusserkennung
- 313: Verknüpfungsschaltung, ODER-Gatter
- 314: Relais in Ruhestromschaltstufe
- 315: Eingangsschaltung
- RS: Mess-Shunt-Widerstand
- M1: MOS-FET
- U1: Operationsverstärker
- V1: Referenzspannung
- MS: Schaltung zur Überbrückung des Mess-Shunt-Widerstandes

## Patentansprüche

1. Vorrichtung zum Überwachen und Schalten eines Lastkreises (103)
a) mit einem Eingangsteil (130) und einem Ausgangsteil (131),
b) mit Schalteingängen (209, 210) zum Anschließen einer Steuerung (101) am Eingangsteil (130),
c) mit Schaltausgängen (121, 122) zum Anschließen mindestens eines Lastkreises (103, 113a, 113b, 113c) mit mindestens einer zu schaltenden Last (126a, 126b, 126c) am Ausgangsteil (131),
d) mit mindestens einem Lastschalter (118, 119) zum Schalten, insbesondere zum Ein- und Ausschalten, der mindestens einen Last (126a, 126b, 126c),
e) wobei das Eingangsteil (130) eine Eingangsschaltung (215;315) aufweist, die über die Schalteingänge (209, 210) eingehende Schaltbefehle der Steuerung (101) in Schaltvorgänge der Lastschalter (118, 119) umsetzt,
f) mit einer ersten, dem Lastkreis parallel geschalteten Fehlerdetektionsschaltung (211) zur Detektion von Fehlern im Lastkreis und
g) mit einer zweiten, mit dem Lastkreis in Reihe geschalteten Fehlerdetektionsschaltung (212) zur Detektion von Fehlern im Lastkreis
h) wobei die erste und die zweite Fehlerdetektionsschaltung jeweils intermediäre Fehlersignale erzeugen, die in einer Verknüpfungsschaltung (213, 313) logisch zu einem Gesamt-Fehlersignal verknüpft werden, und wobei das Gesamt-Fehlersignal von dem Ausgangsteil (131) auf das Eingangsteil (130) übertragen (135) und über die Schalteingänge (209, 210) zur Auswertung zur Verfügung gestellt wird.

2. Vorrichtung nach Anspruch 1,
**dadurch gekennzeichnet,**
**dass** das Gesamt-Fehlersignal an eine Schaltstufe (214, 309, 314) im Eingangsteil (130) der Vorrichtung übertragen wird, wobei diese Schaltstufe (214, 309, 314) einen Zustand von mindestens zwei möglichen Zuständen in Abhängigkeit davon einnimmt, ob ein Fehler oder welcher Fehlertyp im Lastkreis detektiert wurde.

3. Vorrichtung nach Anspruch 1 oder 2,
**dadurch gekennzeichnet,**
**dass** die Verknüpfungsschaltung (213, 313) eine ODER-Verknüpfung der intermediären Fehlersignale bewirkt.

4. Vorrichtung nach einem der Ansprüche 1 bis 3,,
**dadurch gekennzeichnet,**
**dass** die erste Fehlerdetektionsschaltung (211) eine Stromregelung (311a) zum Entnehmen eines Prüfstroms aus dem Lastkreis (103, 113a), aufweist, wobei das von der ersten Fehlerdetektionsschaltung (211) erzeugte erste intermediäre Fehlersignal unterschiedlich ist, je nachdem, ob der Prüfstrom fließt oder unterbrochen ist.

5. Vorrichtung nach Anspruch 4,
**dadurch gekennzeichnet,**
**dass** die erste Fehlerdetektionsschaltung (211) einen Gleichrichter zur Gleichrichtung des Prüfstroms aufweist.

6. Vorrichtung nach einem der Ansprüche 4 oder 5,
**dadurch gekennzeichnet,**
**dass** der Prüfstrom gegenüber einem im Lastfall im Lastkreis fließenden Strom vernachlässigbar klein und vorzugsweise konstant ist.

7. Vorrichtung nach einem der vorhergehenden Ansprüche,
**dadurch gekennzeichnet,**
**dass** die erste Fehlerdetektionsschaltung (211) eine Schaltung (311b) zur Erkennung eines Leitungsbruchfehlers im Lastkreis aufweist.

8. Vorrichtung nach einem der vorhergehenden Ansprüche,
**dadurch gekennzeichnet,**
**dass** die zweite Fehlerdetektionsschaltung (212) eine Schaltung zur Erkennung eines Leitungsbruchfehlers im Lastkreis (312a) aufweist.

9. Vorrichtung nach einem der vorhergehenden Ansprüche,
**dadurch gekennzeichnet, dass** die zweite Fehlerdetektionsschaltung (212) eine Schaltung (312b) zur Erkennung eines Kurzschlussfehlers im Lastkreis aufweist.

10. Vorrichtung nach einem der Ansprüche 2 bis 9,
**dadurch gekennzeichnet,**
**dass** die Schaltstufe (309) einen Ruhestrom in einem Ruhestrompfad (314) im Eingangsteil schaltet.

11. Vorrichtung nach einem der Ansprüche 4 bis 10,
**dadurch gekennzeichnet,**
**dass** der Ruhestrom im Wesentlichen gleiche Stärke wie der Prüfstrom hat.

12. Vorrichtung nach einem der vorhergehenden Ansprüche,
**dadurch gekennzeichnet,**
**dass** das Gesamt-Fehlersignal vom Ausgangsteil (131) auf das Eingangsteil (130) in galvanisch getrennter Weise übertragen wird.

13. Vorrichtung nach einem der vorhergehenden Ansprüche,
**dadurch gekennzeichnet,**
**dass** die Eingangsschaltung (215, 315) eine Spule (117) aufweist, die mit wenigstens einem Lastschalter (118, 119) in Wirkverbindung steht.

14. Verfahren zum Überwachen und Schalten eines Lastkreises (103) mit einer Last (126a, 126b, 126c),
a) bei dem zwischen eine Steuerung (101) und den Lastkreis (103) eine Vorrichtung mit einem Eingangsteil (130) und einem Ausgangsteil (131) geschaltet wird oder ist,
a1) bei dem die Last (126a, 126b, 126c) mit mindestens einem Lastschalter (118, 119) geschaltet wird, insbesondere ein- und ausgeschaltet wird,
b) bei dem das Eingangsteil (130) eine Eingangsschaltung (215, 315) aufweist, die über Schalteingänge (209, 210) eingehende Schaltbefehle der Steuerung (101) in Schaltvorgänge der Lastschalter (118, 119) umsetzt,
c) bei dem mindestens eine erste, dem Lastkreis parallel geschaltete Fehlerdetektionsschaltung (211), und mindestens eine zweite, seriell zum Lastkreis geschaltete Fehlerdetektionsschaltung (212) Fehler im Lastkreis detektieren und mindestens je ein intermediäres Fehlersignal im Ausgangsteil (131) erzeugen,
d) bei dem eine Verknüpfungsschaltung (213, 313) aus den intermediären Fehlersignalen ein aus diesen intermediären Fehlersignalen abgeleitetes Gesamt-Fehlersignal erzeugt und von dem Ausgangsteil (131) auf das Eingangsteil (130) überträgt (135), und
e) bei dem das Gesamt-Fehlersignal über die Schalteingänge (209, 210) zur Auswertung zur Verfügung gestellt wird.

15. Verfahren nach Anspruch 14, bei dem zwischen die Steuerung (101) und den Lastkreis (103) eine Vorrichtung nach einem der Ansprüche 1 bis 13 geschaltet wird oder ist.

## Claims

1. Device for monitoring and switching a load circuit (103), having
a) an input part (130) and an output part (131),
b) switching inputs (209, 210) to connect a controller (101) to the input part (130),
c) switching outputs (121, 122) to connect at least one load circuit (103, 113a, 113b, 113c) with at least one load (126a, 126b, 126c) to be switched to the output part (131),
d) at least one load switch (118, 119) for switching, in particular for switching on and off, the at least one load (126a, 126b, 126c),
e) wherein the input part (130) has an input circuit (215; 315) which converts switching commands of the controller (101) incoming via the switching inputs (209, 210) into switching processes of the load switches (118, 119),
f) having a first fault detection circuit (211), connected in parallel with the load circuit, to detect faults in the load circuit and
g) having a second fault detection circuit (212), connected in series with the load circuit, to detect faults in the load circuit,
h) wherein the first and the second fault detection circuits each generate intermediate fault signals which are logically linked in a logic circuit (213, 313) to form an overall fault signal, and wherein the overall fault signal is transmitted (135) from the output part (131) to the input part (130) and made available via the switching inputs (209, 210) for evaluation.

2. Device according to claim 1,
**characterised in that**
the overall fault signal is transmitted to a switching stage (214, 309, 314) in the input part (130) of the device, wherein this switching stage (214, 309, 314) assumes one of at least two possible states in dependence upon whether a fault or which fault type has been detected in the load circuit.

3. Device according to claim 1 or 2,
**characterised in that**
the logic circuit (213, 313) brings about an OR-operation of the intermediate fault signals.

4. Device according to one of claims 1 to 3,
**characterised in that**
the first fault detection circuit (211) has a current regulator (311a) to take a test current from the load circuit (103, 113a), wherein the first intermediate fault signal generated by the first fault detection circuit (211) is different depending upon whether the test current flows or is interrupted.

5. Device according to claim 4,
**characterised in that**
the first fault detection circuit (211) has a rectifier to rectify the test current.

6. Device according to one of claims 4 or 5,
**characterised in that**
the test current is negligibly small in relation to a current flowing in the load circuit in the case of a load and is preferably constant.

7. Device according to one of the preceding claims,
**characterised in that**
the first fault detection circuit (211) has a circuit (311b) for detecting a line break fault in the load circuit.

8. Device according to one of the preceding claims,
**characterised in that**
the second fault detection circuit (212) has a circuit for detecting a line break fault in the load circuit (312a).

9. Device according to one of the preceding claims,
**characterised in that**
the second fault detection circuit (212) has a circuit (312b) to detect a short circuit fault in the load circuit.

10. Device according to one of claims 2 to 9,
**characterised in that**
the switching stage (309) switches a no-load current in a no-load current path (314) in the input part.

11. Device according to one of claims 4 to 10,
**characterised in that**
the no-load current has essentially the same strength as the test current.

12. Device according to one of the preceding claims,
**characterised in that**
the overall fault signal is transmitted from the output part (131) to the input part (130) in a galvanically isolated way.

13. Device according to one of the preceding claims,
**characterised in that**
the input circuit (215, 315) has a coil (117) which is in active connection with at least one load switch (118, 119).

14. Method for monitoring and switching a load circuit (103) with a load (126a, 126b, 126c),
a) wherein a device with an input part (130) and an output part (131) is connected or is being connected between a controller (101) and the load circuit (103),
a1) wherein the load (126a, 126b, 126c) is switched with at least one load switch (118, 119), and is in particular switched on and off,
b) wherein the input part (130) has an input circuit (215, 315) which converts switching commands of the controller (101) incoming via switching inputs (209, 210) into switching processes of the load switches (118, 119),
c) wherein at least a first fault detection circuit (211), connected in parallel with the load circuit, and at least a second fault detection circuit (212), connected in series with the load circuit, detect faults in the load circuit and generate, in each case, at least one intermediate fault signal in the output part (131),
d) wherein a logic circuit (213, 313) generates an overall fault signal from the intermediate fault signals derived from these intermediate fault signals and transmits it (135) from the output part (131) to the input part (130), and
e) wherein the overall fault signal is made available via the switching inputs (209, 210) for evaluation.

15. Method according to claim 14,
wherein a device according to one of claims 1 to 13 is connected or is being connected between the controller (101) and the load circuit (103).

## Revendications

1. Dispositif de surveillance et de commutation d'un circuit de charge (103) comprenant
a) une partie d'entrée (130) et une partie de sortie (131),
b) des entrées de commutation (209, 210) pour le raccordement d'une commande (101) à la partie d'entrée (130),
c) des sorties de commutation (121, 122) pour le raccordement d'au moins un circuit de charge (103, 113a, 113b, 113c) comprenant au moins une charge (126a, 126b, 126c) à commuter à la partie de sortie (131),
d) au moins un commutateur de charge (118, 119) pour la commutation, en particulier pour la mise en service et hors service, de la au moins une charge (126a, 126b, 126c),
e) dans lequel la partie d'entrée (130) présente un circuit d'entrée (215 ; 315), qui convertit les instructions de commutation de la commande (101) entrant par les entrées de commutation (209, 210) en processus de commutation des commutateurs de charge (118, 119),
f) un premier circuit de détection de défaut (211) monté en parallèle du circuit de charge et destiné à détecter des défauts dans le circuit de charge et
g) un deuxième circuit de détection de défaut (212) monté en série avec le circuit de charge et destiné à détecter des défauts dans le circuit de charge
h) dans lequel le premier et le deuxième circuit de détection de défaut génèrent respectivement des signaux de défaut intermédiaires, qui sont combinés de manière logique dans un circuit combinatoire (213, 313) en un signal global de défaut, et dans lequel le signal global de défaut est transmis (135) de la partie de sortie (131) à la partie d'entrée (130) et fourni pour évaluation par l'intermédiaire des entrées de commutation (209, 210).

2. Dispositif selon la revendication 1,
**caractérisé**
**en ce que** le signal global de défaut est transmis à un étage de commutation (214, 309, 314) dans la partie d'entrée (130) du dispositif, dans lequel cet étage de commutation (214, 309, 314) occupe un état parmi au moins deux états possibles selon qu'un défaut a été détecté dans le circuit de charge ou en fonction du type de défaut détecté.

3. Dispositif selon la revendication 1 ou 2,
**caractérisé**
**en ce que** le circuit combinatoire (213, 313) provoque une combinaison OU des signaux de défaut intermédiaires.

4. Dispositif selon l'une quelconque des revendications 1 à 3,
**caractérisé**
**en ce que** le premier circuit de détection de défaut (211) présente une régulation de courant (311a) destinée à prélever un courant d'essai du circuit de charge (103, 113a), dans lequel le premier signal de défaut intermédiaire généré par le premier circuit de détection de défaut (211) est différent selon que le courant d'essai circule ou est interrompu.

5. Dispositif selon la revendication 4,
**caractérisé**
**en ce que** le premier circuit de détection de défaut (211) présente un redresseur pour le redressement du courant d'essai.

6. Dispositif selon l'une quelconque des revendications 4 ou 5,
**caractérisé**
**en ce que** le courant d'essai est en quantité négligeable et de préférence constant par rapport à un courant circulant dans le circuit de charge en cas de charge.

7. Dispositif selon l'une quelconque des revendications précédentes,
**caractérisé**
**en ce que** le premier circuit de détection de défaut (211) présente un circuit (311b) destiné à détecter un défaut de rupture de ligne dans le circuit de charge.

8. Dispositif selon l'une quelconque des revendications précédentes,
**caractérisé**
**en ce que** le deuxième circuit de détection de défaut (212) présente un circuit de détection d'un défaut de rupture de ligne dans le circuit de charge (312a).

9. Dispositif selon l'une quelconque des revendications précédentes,
**caractérisé en ce que** le deuxième circuit de détection de défaut (212) présente un circuit (312b) destiné à détecter un défaut de court-circuit dans le circuit de charge.

10. Dispositif selon l'une quelconque des revendications 2 à 9,
**caractérisé**
**en ce que** l'étage de commutation (309) commute un courant de repos dans un trajet de courant de repos (314) dans la partie d'entrée.

11. Dispositif selon l'une quelconque des revendications 4 à 10,
**caractérisé**
**en ce que** le courant de repos présente sensiblement la même intensité que le courant d'essai.

12. Dispositif selon l'une quelconque des revendications précédentes,
**caractérisé**
**en ce que** le signal global de défaut est transmis de la partie de sortie (131) à la partie d'entrée (130) d'une manière séparée galvaniquement.

13. Dispositif selon l'une quelconque des revendications précédentes,
**caractérisé**
**en ce que** le circuit d'entrée (215, 315) présente une bobine (117) qui est en liaison fonctionnelle avec au moins un commutateur de charge (118, 119).

14. Procédé de surveillance et de commutation d'un circuit de charge (103) comprenant une charge (126a, 126b, 126c),
a) selon lequel un dispositif comprenant une partie d'entrée (130) et une partie de sortie (131) devient ou est commuté entre une commande (101) et le circuit de charge (103),
a1) selon lequel la charge (126a, 126b, 126c) est commutée, en particulier mise en service et hors service, au moyen d'au moins un commutateur de charge (118, 119),
b) selon lequel la partie d'entrée (130) présente un circuit d'entrée (215, 315), qui convertit les instructions de commutation de la commande (101) entrant par les entrées de commutation (209, 210) en processus de commutation des commutateurs de charge (118, 119),
c) selon lequel au moins un premier circuit de détection de défaut (211) monté en parallèle du circuit de charge, et au moins un deuxième circuit de détection de défaut (212) monté en série par rapport au circuit de charge détectent des défauts dans le circuit de charge et génèrent au moins chacun un signal de défaut intermédiaire dans la partie de sortie (131),
d) selon lequel un circuit combinatoire (213, 313) génère à partir des signaux de défaut intermédiaires un signal de défaut global dérivé de ces signaux de défaut intermédiaires et le transmet (135) de la partie de sortie (131) à la partie d'entrée (130), et
e) selon lequel le signal global de défaut est fourni par l'intermédiaire des entrées de commutation (209, 210) aux fins d'évaluation.

15. Procédé selon la revendication 14, selon lequel un dispositif selon l'une quelconque des revendications 1 à 13 devient ou est commuté entre la commande (101) et le circuit de charge (103).
